# EUROPÄISCHE PATENTSCHRIFT

(11) **EP 2 382 673 B1**
(45) Veröffentlichungstag und Bekanntmachung des Hinweises auf die Patenterteilung: **30.01.2019**
(21) Anmeldenummer: 09798937.0
(22) Anmeldetag: 23.12.2009
(51) Int. Cl.: H01L 25/075, H01L 33/50, H01L 33/58

(54) **OPTOELEKTRONISCHES HALBLEITERBAUTEIL UND VERFAHREN ZU SEINER HERSTELLUNG**
OPTOELECTRONIC SEMICONDUCTOR COMPONENT AND METHOD OF ITS FABRICATION
COMPOSANT SEMI-CONDUCTEUR OPTOÉLECTRONIQUE ET PROCÉDÉ DE SA FABRICATION

(30) Priorität: 23.01.2009 DE 102009005907
(43) Veröffentlichungstag der Anmeldung: 02.11.2011
(73) Patentinhaber: OSRAM Opto Semiconductors GmbH, 93055 Regensburg (DE)
(72) Erfinder: ENGL, Moritz, 93055 Regensburg (DE); SORG, Jörg Erich, 93053 Regensburg (DE); ZEILER, Thomas, 93152 Nittendorf (DE); REILL, Joachim, 93197 Zeitlarn (DE)
(74) Vertreter: Epping - Hermann - Fischer
(86) Internationale Anmeldenummer: PCT/EP2009/067888
(87) Internationale Veröffentlichungsnummer: WO 2010/083929

(56) Entgegenhaltungen:
- EP-A2- 1 906 462
- WO-A-03/098707
- WO-A1-2008/072196
- WO-A2-2008/007232
- WO-A2-2008/091319
- DE-A1-102006 024 165
- DE-A1-102007 055 170
- DE-A1-102008 054 029
- DE-C1- 19 845 229
- GB-A- 2 373 368
- JP-A- 2000 022 222
- JP-A- 2003 110 146
- US-A- 3 875 456
- US-A1- 2006 138 938
- US-A1- 2008 179 618
- US-B1- 6 271 631

## Beschreibung

Es wird ein optoelektronisches Halbleiterbauteil angegeben.

Diese Patentanmeldung beansprucht die Priorität der deutschen Patentanmeldung 10 2009 005 907.5.

Eine zu lösende Aufgabe besteht darin, ein optoelektronisches Halbleiterbauteil anzugeben, das eine gleichmäßige über das Bauteil verteilte Strahlungsemission ermöglicht und so die Wahrnehmung von Helligkeitsunterschieden für einen externen Betrachter des Bauteils verringert wird.

Das Dokument JP 2000 022222 A offenbart ein optoelektronisches Halbleiterbauteil, bei dem zwei strahlungsemittierenden Halbleiterchips ein gemeinsames Konverterelement und ein gemeinsames Streuelement nachgeordnet sind. Der Verbund aus dem Streuelement und dem Konverterelement ist mittels einer Klemmvorrichtung auf den Halbleiterchips befestigt.

Das erfindungsgemäße optoelektronische Halbleiterbauteil umfasst eine Vielzahl von insbesondere matrixartig angeordneten, strahlungsemittierenden Halbleiterchips, wobei die Halbleiterchips auf einem gemeinsamen Träger aufgebracht sind, und wobei die Halbleiterchips jeweils eine vom Träger abgewandte Strahlungsaustrittsfläche aufweisen. Weiter umfasst das optoelektronische Halbleiterbauteil eine Vielzahl von Konverterelementen, die den Halbleiterchips zur Konversion von von den Halbleiterchips emittierter elektromagnetischer Strahlung nachgeordnet sind. Ferner umfasst das optoelektronische Halbleiterbauteil genau ein Streuelement zum diffusen Streuen von von den Halbleiterchips emittierter elektromagnetischer Strahlung, das alle Halbleiterchips überdeckt, wobei das genau eine Streuelement eine zusammenhängende Strahlungsaustrittsfläche aufweist. Das genau eine Streuelement ist eine Licht streuende Folie oder ein Licht streuendes Plättchen. Das genau eine Streuelement steht mit den Konverterelementen in direktem Kontakt. Die Konverterelemente und das genau eine Streuelement bilden einen Verbund, der auf den zugehörigen Halbleiterchips mittels eines Klebers aufgebracht ist, so dass jedes Konverterelement eineindeutig einem Halbleiterchip zugeordnet ist. Die Konverterelemente bedecken ausschließlich die Strahlungsaustrittsflächen der zugehörigen Halbleiterchips, so dass die Konverterelemente Seitenflächen der zugehörigen Halbleiterchips nicht bedecken, wobei die Seitenflächen quer zu den Strahlungsaustrittsflächen verlaufen.

Das Halbleiterbauteil umfasst eine Vielzahl von insbesondere matrixartig angeordneten, strahlungsemittierenden Halbleiterchips. Die Halbleiterchips sind auf einem gemeinsamen Träger aufgebracht. "Matrixartig" bedeutet in diesem Zusammenhang, dass die Vielzahl der strahlungsemittierenden Halbleiterchips vorzugsweise in Form von Zeilen und Spalten auf dem Träger aufgebracht sind. Dabei müssen die Halbleiterchips nicht zwingend in einem regelmäßigen Gitter auf dem Träger aufgebracht sein. Beispielsweise sind zwischen den matrixartig angeordneten Halbleiterchips Zwischenräume ausgebildet. Mit anderen Worten sind die Halbleiterchips dann beabstandet zueinander

angeordnet. In einer Draufsicht auf das Bauteil sind die Zwischenräume durch die Seitenflächen zweier jeweils aneinander angrenzender Halbeiterchips und der den Halbleiterchips zugewandten Oberfläche des Trägers begrenzt.

Bei den strahlungsemittierenden Halbleiterchips kann es sich beispielsweise um Lumineszenzdiodenchips handeln. Bei den Lumineszenzdiodenchips kann es sich um Leucht- oder Laserdiodenchips handeln, die Strahlung im Bereich von ultraviolettem bis infrarotem Licht emittieren. Vorzugsweise emittieren die Lumineszenzdiodenchips Licht im sichtbaren oder ultravioletten Bereich des Spektrums der elektromagnetischen Strahlung. Bei dem gemeinsamen Träger kann es sich um eine Leiterplatte oder einen Trägerrahmen (Leadframe) handeln. Das Bauteil ist zum Beispiel oberflächenmontierbar. Der Träger kann mit einem duro- oder thermoplastischen Material oder auch mit einem keramischen Material gebildet sein, oder aus einem solchen bestehen. Die matrixartig angeordneten, strahlungsemittierenden Halbleiterchips sind auf dem gemeinsamen Träger aufgebracht.

Eine Vielzahl von Konverterelementen zur Konversion von vom Halbleiterchip emittierter elektromagnetischer Strahlung sind den Halbleiterchips nachgeordnet. Die Konverterelemente sind entlang eines Strahlaustrittswegs des Halbleiterbauteils den Halbleiterchips nachgeordnet. Der Strahlaustrittsweg ist der Weg der Strahlung von der Emission durch den Halbleiterchip bis zur Auskopplung der elektromagnetischen Strahlung aus dem Bauteil. Die Konverterelemente wandeln Licht einer Wellenlänge in Licht einer anderen Wellenlänge um. Beispielsweise wandeln die Konverterelemente von den Halbleiterchips primär emittiertes blaues Licht teilweise in gelbes Licht um, das sich zusammen mit dem blauen Licht zu weißem Licht vermischen kann. Die Konverterelemente haben also im Betrieb des Halbleiterbauteils die Funktion eines Lichtkonverters. Vorzugsweise sind die Konverterelemente auf Strahlungsaustrittsflächen der Halbleiterchips aufgebracht und stehen dabei in direktem Kontakt mit den Halbleiterchips. Beispielsweise kann dies durch Aufkleben der Konverterelemente auf den Halbleiterchips erreicht sein. In einer Abwandlung ist es auch möglich, dass die Konverterelemente mittels eines Siebdruckverfahrens auf die Strahlungsaustrittsflächen der Halbleiterchips aufgebracht sind. Dies ermöglicht vorteilhaft eine chipnahe Farbkonversion der vom Halbleiterchip primär emittierten elektromagnetischen Strahlung. Es besteht aber auch die Möglichkeit, dass die Konverterelemente nur mittelbar mit den Halbleiterchips in Kontakt stehen. Das kann heißen, dass sich zwischen der Grenzfläche Konverterelement/Halbleiterchip ein Spalt ausbildet und sich so das Konverterelement und der Halbleiterchip nicht berühren. Der Spalt kann mit einem Gas, beispielsweise Luft, gefüllt sein.

Die Konverterelemente können mit einem Silikon, einem Epoxid, einer Mischung aus Silikon und Epoxid oder einer transparenten Keramik gebildet sein, in das Partikel eines Konversionsstoffs eingebracht sind.

Es ist jedem Halbleiterchip genau ein Konverterelement zugeordnet. Dabei ist jedem Halbleiterchip ein Konverterelement eindeutig zugeordnet ist.

Das optoelektronische Halbleiterbauteil umfasst genau ein den Halbleiterchips nachfolgendes Streuelement zum diffusen Streuen von von den Halbleiterchips emittierter elektromagnetischer Strahlung. Das Streuelement steht mit den Konverterelementen in direktem Kontakt. Das Streuelement umfasst zum Beispiel ein Matrixmaterial, in das zusätzlich strahlungsstreuende Partikel eingebracht sind. Die von den Halbleiterchips emittierte elektromagnetische Strahlung wird dann an den strahlungsstreuenden Partikeln (auch Diffusorpartikel) gestreut. Ebenso ist es möglich, dass das Streuelement zum Beispiel als aufgeraute Platte aus transparentem Material ausgebildet ist. In der Ausgestaltung des Streuelements gibt es wenigstens zwei Möglichkeiten. Erfindungsgemäß folgt genau ein Streuelement allen Halbleiterchips nach. In einer Abwandlung kann jedem Halbleiterchip ein eigenes Streuelement nachfolgen und damit eindeutig zugeordnet sein. Es konnte gezeigt werden, dass die von Halbleiterchips emittierte elektromagnetische Strahlung durch das Streuelement besonders gleichmäßig wird, sodass in der Abstrahlcharakteristik des Bauteils Inhomogenitäten vermieden und Intensitätsspitzen geglättet werden. Vorteilhaft wird somit für einen externen Betrachter ein Blendeffekt vermieden und eine Strahlungsaustrittsfläche des Bauteils erscheint so vorteilhaft homogener und gleichmäßiger in ihrer Helligkeit.

"Abstrahlcharakteristik" bezieht sich in diesem Zusammenhang auf die Lichtabstrahlungseigenschaften wie Intensität und Farbe in Abhängigkeit von der Abweichung zur optischen Achse des Halbleiterbauteils.

Die optische Achse des Bauteils verläuft beispielsweise senkrecht zu der den Halbleiterchips zugewandten Oberfläche des Trägers des Bauteils.

Die Strahlungsaustrittsfläche des Bauteils ist beispielsweise die Fläche, die durch eine Umrandung aller Streuelemente oder der Konverterelemente eingeschlossen ist.

Ein weiterer Vorteil des Einbringens eines solchen Streuelements liegt darin, dass von außen einfallendes Fremdlicht diffus vom Streuelement reflektiert wird, sodass das diffus reflektierte Fremdlicht die vom Bauteil erzeugte elektromagnetische Strahlung nicht überlagert. Dies hat den Vorteil zur Folge, dass ein solches Streuelement neben den bereits genannten Effekten zusätzlich den Farblichtkontrast erhöht.

Ferner stehen das Streuelement und die Konverterelemente in direktem Kontakt miteinander. Das heißt, dass sich an der Grenzfläche Streuelement/Konverterelemente weder ein Spalt noch ein Zwischenraum oder eine Unterbrechung ausbildet. Vorteilhaft ermöglicht dies, dass möglichst viel von den Konverterelementen emittierte oder durch die Konverterelemente transmittierte elektromagnetische Strahlung durch das Streuelement erfasst und so diffus gestreut wird. Beispielsweise kann dies dadurch erreicht werden, dass das Streuelement auf die Konverterelemente aufgeklebt oder mittels eines Siebdruckprozesses das Streuelement auf die Konverterelemente aufgerakelt wird.

Das hier beschriebene optoelektronische Halbleiterbauteil beruht dabei unter anderem auf der Erkenntnis, dass für einen externen Betrachter der Strahlungsaustrittsfläche des Bauteils durch die Zwischenräume hindurch der Träger des Bauteils erkennbar ist und dadurch Helligkeitsunterschiede bei Betrachtung der Strahlungsaustrittsfläche des Bauteils auftreten, falls kein Streuelement vorhanden ist.

Für einen externen Betrachter ergibt sich so ein inhomogenes Abstrahlungsbild von hell leuchtenden Bereichen, auf denen sich die Halbleiterchips befinden, und von dunklen, nicht leuchtenden Bereichen, die die Zwischenräume zwischen den Halbleiterchips darstellen. Um nun ein solches inhomogenes Abstrahlungsbild zu vermeiden, macht das hier beschriebene Bauelement von der Idee Gebrauch, ein Streuelement jedem Halbleiterchip nachzuordnen, wobei das Streuelement mit den Konverterelementen in direktem Kontakt steht. Das Problem der für einen externen Betrachter dunkel erscheinenden Zwischenräume des Bauteils ist dann dadurch gelöst, dass in einer Draufsicht auf die Strahlungsaustrittsfläche des Bauteils die dunkel erscheinenden Zwischenräume von der durch die Streuelemente diffus gestreuten elektromagnetischen Strahlung überlagert werden. Bei einer Betrachtung der Strahlungsaustrittsfläche des Bauteils überlagern sich so die dunkel erscheinenden Zwischenräume zumindest stellenweise mit der von den Streuelementen von Bereichen der Zwischenräume aus diffus gestreuter elektromagnetischer Strahlung.

Dies erweckt für einen Betrachter den Eindruck eines gleichmäßig strahlungsemittierenden Bauteils, bei dem Leuchtdichteunterschiede über die Strahlungsaustrittsfläche verringert sind. "Leuchtdichte" ist in diesem Zusammenhang ein Maß für die Helligkeit der Strahlungsaustrittsfläche des Bauteils und ist mit Lichtstärke pro Fläche definiert. Dadurch erscheint das Bauteil von seiner Strahlungsaustrittsfläche für einen externen Betrachter homogener in seiner Helligkeit.

Vorteilhaft werden durch das Aufbringen des Streuelements auf die Halbleiterchips Blendeffekte vermieden, da das Streuelement die von den Halbleiterchips emittierte elektromagnetische Strahlung diffus streut, wodurch in der Abstrahlcharakteristik des Bauteils Inhomogenitäten und Intensitätsspitzen vermieden werden.

Gemäß zumindest einer Ausführungsform beträgt der seitliche Abstand zwischen benachbarten Halbleiterchips zwischen 1 und 150 µm, bevorzugt zwischen 10 und 150 µm. Das heißt, dass der Abstand zweier Seitenflächen zweier benachbarter Chips zwischen 10 und 150 µm beträgt. Dies ermöglicht ein ganz besonders kompaktes und platzsparendes Halbleiterbauteil. Weiter bietet dies die Möglichkeit, den Raum, den die Zwischenräume einnehmen, möglichst klein zu halten.

Gemäß zumindest einer Ausführungsform des optoelektronischen Halbleiterbauteils ist das Streuelement mit einem Matrixmaterial gebildet, in das strahlungsstreuende Partikel (auch Diffusorpartikel) eingebracht sind. Bei dem Matrixmaterial kann es sich um ein Silikon, ein Epoxid oder eine Mischung aus Silikon und Epoxid handeln. Das Streuelement kann ebenso auch mit einem keramischen Material gebildet sein. In das Matrixmaterial sind strahlungsstreuende Partikel eingebracht, die auf das Matrixmaterial einfallende Strahlung diffus streuen. Vorzugsweise handelt es sich bei dem Matrixmaterial um ein Material, welches für die vom Halbleiterchip erzeugte elektromagnetische Strahlung transparent ist, um eine möglichst hohe Strahlungsauskopplung aus dem Bauteil sicherzustellen.

Gemäß zumindest einer Ausführungsform des optoelektronischen Halbleiterbauteils besteht zumindest ein strahlungsstreuender Partikel zumindest aus den Materialien Siliziumdioxid (SiO₂), ZrO₂, TiO₂ und/oder AlₓO_{y} oder enthält zumindest eines dieser Materialien. Beispielsweise kann es sich bei dem Aluminiumoxid um Al₂O₃ handeln. Die strahlungsstreuenden Partikel werden vor dem Einbringen in das Halbleiterbauteil mit dem Matrixmaterial vermengt. Vorzugsweise werden die strahlungsstreuenden Partikel derart im Matrixmaterial verteilt, dass die Konzentration der strahlungsstreuenden Partikel im ausgehärteten Matrixmaterial gleichmäßig ist. Vorzugsweise streut das zu einem Streuelement ausgehärtete Matrixmaterial elektromagnetische Strahlung isotrop. Durch die Streuung der emittierten Strahlung an den Partikeln wird ebenso die Farbhomogenität verbessert und die elektromagnetische Strahlung in ihren Intensitäten geglättet. "Farbhomogenität" bedeutet dabei die Stabilität des Farbtons über die räumliche Abstrahlung durch die Strahlungsaustrittsfläche des Streuelements.

Gemäß zumindest einer Ausführungsform des optoelektronischen Halbleiterbauteils beträgt die Konzentration der strahlungsstreuenden Partikel im Matrixmaterial mehr als 1 Gew-%. Bevorzugt beträgt die Konzentration mehr als 5 Gew-%. Es konnte gezeigt werden, dass ab einer solchen Konzentration der strahlungsstreuenden Partikel in den Streuelementen die vom Halbleiterchip emittierte elektromagnetische Strahlung so diffus durch das Streuelement gestreut wird, dass die Wahrnehmung der dunkel erscheinenden Zwischenräume auf die Strahlungsaustrittsfläche für einen externen Betrachter verringert ist.

Gemäß zumindest einer Ausführungsform des Halbleiterbauteils ist das e Streuelement aus einem Matrixmaterial gebildet, in das Mikrostrukturen eingebracht sind. Das heißt, dass die Mikrostrukturen in Form von beispielsweise grobkörnigen Mikrostrukturen (auch Körnchen) in das Matrixmaterial eingebracht sind. Vorzugsweise weisen die grobkörnigen Mikrostrukturen einen unterschiedlichen Brechungsindex zu dem sie umgebenden Matrixmaterial auf, so dass die elektromagnetische Strahlung diffus an den Mikrostrukturen gestreut oder optisch gebrochen wird. Die grobkörnigen Mikrostrukturen können mit einem Silikon, einem Epoxid oder einer Mischung aus Silikon und Epoxid gebildet sein.

Das genau eine Streuelement ist eine Licht streuende Folie oder ein Licht streuendes Plättchen. Das heißt, dass entlang des Strahlaustrittswegs des Halbleiterbauteils die Licht streuende Folie oder das Plättchen direkt auf die Konverterelement folgt und die von den Halbleiterchips emittierte elektromagnetische Strahlung diffus streut. Beispielsweise ist die Licht streuende Folie oder das Plättchen auf die den Halbleiterchips abgewandte Oberseite der Konverterelemente aufgeklebt. Vorzugsweise stehen die Konverterelemente und die Licht streuende Folie oder das Plättchen in direktem Kontakt miteinander und es bildet sich an der Grenzfläche Konverterelement/Folie beziehungsweise Konverterelement/Plättchen weder ein Spalt noch eine Unterbrechung aus. Vorzugsweise umfasst die Dicke der Folie 10 bis 50 µm, besonders bevorzugt 30 µm. Vorzugsweise weist das Plättchen eine Dicke von 500 µm bis 1 mm auf. Die Folie oder das Plättchen sind mit einem für elektromagnetische Strahlung transparentem Material, wie Silikon, gebildet, in das vor dem Aushärten zu der Folie oder dem Plättchen strahlungsstreuende Partikel eingebracht wurden. Vorzugsweise weist die Licht streuende Folie eine Konzentration der strahlungsstreuenden Partikel von mehr als 5 Gew-% auf.

Alternativ kann das Licht streuende Plättchen auch mit einem keramischen Material gebildet sein.

Zusätzlich oder alternativ zum Einbringen von strahlungsstreuenden Partikeln in das Matrixmaterial können sowohl die Folie als auch das Plättchen Strukturierungen ihrer Außenflächen, beispielsweise Aufrauungen, aufweisen. Die Folie oder das Plättchen können nach dem Aushärten auf die den Halbleiterchips abgewandte Oberfläche der Konverterelemente aufgeklebt werden. Das zähflüssige Material kann ebenso direkt aufgebracht werden, und dann aushärten.

Gemäß einer Abwandlung ist jedem Halbleiterchip genau ein Streuelement nachgeordnet, wobei das Streuelement das dem Halbleiterchip zugeordnete Konverterelement seitlich überragt. Das Streuelement wird mittels Kleben, Siebdruck oder ähnlichem auf die dem Halbleiterchip abgewandte Oberseite des ihm zugeordneten Konverterelements aufgebracht. Vorzugsweise überragt das Streuelement sowohl das Konverterelement als auch den Halbleiterchip seitlich. Die Streuelemente überragen die Halbleiterchips an allen freiliegenden Seitenflächen bevorzugt wenigstens um 5 und höchstens um 75 µm. Durch eine solche Ausgestaltung des Streuelements wird erreicht, dass die jeweiligen Abstände der auf die Halbleiterchips aufgebrachten Streuelemente voneinander verringert beziehungsweise minimiert werden. Bei Emission elektromagnetischer Strahlung wird die vom Halbleiterchip emittierte elektromagnetische Strahlung diffus gestreut.

Vorzugsweise wird elektromagnetische Strahlung durch die Lichtverteilung im Streuelement auch von Bereichen der Streuelemente diffus gestreut, die in einer Draufsicht auf die Lichtauskoppelfläche zumindest stellenweise die Zwischenräume überdecken. An der Strahlungsaustrittsfläche überlagern sich so zumindest stellenweise die dunkel erscheinenden Zwischenräume mit der von den Streuelementen auch über Bereichen der Zwischenräume aus gestreuter elektromagnetischer Strahlung. Für einen externen Betrachter ergeben sich so vorteilhaft unter Betrachtung der Strahlungsaustrittsfläche des Bauteils geringere Leuchtdichteunterschiede zwischen Bereichen, die elektromagnetische Strahlung emittieren und den Zwischenräumen. Die Strahlungsaustrittsfläche erscheint somit homogener und gleichmäßiger in ihrer Helligkeit, wodurch für den Betrachter der Eindruck eines gleichmäßig über die gesamte Strahlungsaustrittsfläche Strahlung emittierenden Bauteils entsteht.

Erfindungsgemäß ist den Halbleiterchips genau ein Streuelement nachgeordnet, das alle Halbleiterchips überdeckt, wobei das Streuelement eine zusammenhängende Strahlungsaustrittfläche aufweist. Das Streuelement ist eine Folie oder eine Platte, die auf alle die den Halbleiterchips abgewandten Oberseiten der Konverterelemente aufgebracht wurde. Das Streuelement überdeckt in dieser Ausführungsform nicht nur die Halbleiterchips, sondern ebenso die Zwischenräume zwischen den Halbleiterchips vollständig. Vorzugsweise ist das Streuelement so beschaffen, dass es selbstragend ist. Das heißt, dass das Streuelement nach dem Aufbringen keiner weiterer Befestigungs- und Stabilisierungsmaßnahmen bedarf. Vorzugsweise behält dann das Streuelement in Bereichen, in denen es die Zwischenräume überdeckt, seine Form bei, sodass sich weder Bruchstellen, Unebenheiten oder ähnliches im Streuelement ausbilden. Die dunkel erscheinenden Zwischenräume überlagern sich so vorzugsweise vollständig mit der vom Streuelement auch über Bereichen der Zwischenräume aus diffus gestreuter elektromagnetischer Strahlung. So werden die Leuchtdichteunterschiede zwischen Bereichen, die elektromagnetische Strahlung emittieren und Bereichen von Zwischenräumen weiter verringert. Für einen externen Betrachter der Strahlungsaustrittsfläche erscheint so die Emission der elektromagnetischen Strahlung noch gleichmäßiger und über die gesamte Strahlungsaustrittsfläche noch homogener verteilt. Ferner wird vorteilhaft die Blendwirkung für einen externen Betrachter verringert, da die von den Halbleiterchips emittierte elektromagnetische Strahlung durch das Streuelement in ihren Intensitäten geglättet wird. Außerdem wird weiter erreicht, dass der Farbton über die gesamte Strahlungsaustrittsfläche des Bauteils homogenisiert und stabilisiert wird. Ganz besonders ist ein solches Streuelement für ein Bauteil mit einer großen Anzahl von Halbleiterchips geeignet, da die Strahlungsaustrittsfläche des Bauteils dann großflächig ist und so nicht nur die bereits genannten vorteilhaften Leuchteigenschaften des Bauteils zur Geltung kommen, sondern das Streuelement beispielsweise in nur einem einzigen Verfahrensschritt aufgebracht werden kann.

Es wird darüber hinaus ein Verfahren zur Herstellung eines optoelektronischen Bauteils angegeben. Mittels des Verfahrens ist ein hier beschriebenes Bauteil herstellbar. Das heißt, sämtliche in Verbindung mit dem Bauteil offenbarten Merkmale sind auch für das Verfahren offenbart und umgekehrt.

Das Verfahren zur Herstellung eines optoelektronischen Halbleiterbauelements umfasst die Schritte:
- Bereitstellen eines Trägerelements,
- Bilden einer Vielzahl von Konverterelementen mittels eines ersten Siebdruckprozesses auf dem Trägerelement,
- Bilden genau eines Streuelements auf die freiliegenden Außenflächen der Konverterelemente mittels eines zweiten Siebdruckprozesses, so dass ein Verbund aus den Konverterelementen und dem genau einen Streuelement geformt wird,
- Ablösen des Trägerelements von dem Verbund,
- anschließendes Aufbringen des Verbunds bestehend aus den Konverterelementen und dem genau einen Streuelement auf eine Vielzahl strahlungsemittierender Halbleiterchips mittels eines Klebers, sodass jedem Halbleiterchip ein Konverterelement eineindeutig zugeordnet wird.

Es wird bei dem Verfahren zunächst ein Trägerelement bereitgestellt. Bei dem Trägerelement kann es sich beispielsweise um eine Folie handeln.

In einem zweiten Schritt wird mittels eines Siebdruckprozesses eine Vielzahl von Konverterelementen auf dem Trägerelement gebildet. Nach dem Aufbringen einer ersten Schablone wird mittels des Siebdruckprozesses das Material der Konverterelemente auf das Trägerelement aufgebracht, zum Beispiel aufgerakelt. Nach dem Aufbringen und einem eventuellen Aushärten des Materials wird die erste Schablone von dem Trägerelement entfernt. Bei dem Material für die Konverterelemente kann es sich zum Beispiel um eine Schicht mit Silikon oder aus einer transparenten Keramik handeln, in die Konverterpartikel eingebracht sind.

In einem dritten Schritt wird unter Verwendung einer auf das Trägerelement aufgebrachten zweiten Schablone mittels eines zweiten Siebdruckprozesses auf alle freiliegenden Außenflächen der Konverterelemente genau ein Streuelement als eine zweite Schicht aufgebracht. Das Streuelement bedeckt die Konverterelemente an allen freiliegenden Seitenflächen und der dem Trägerelement abgewandten Oberseite. Das Material kann beispielsweise aufgerakelt werden und anschließend aushärten.

Nach dem Ablösen des Trägerelements und der zweiten Schablone vom Verbund bestehend aus den Konverterelementen und zweiter Schicht wird der Verbund auf den strahlungsemittierenden Halbleiterchips aufgebracht.

Im Folgenden wird das hier beschriebene Bauteil sowie das hier beschriebene Verfahren anhand von Ausführungsbeispielen und den dazugehörigen Figuren näher erläutert.
Die Figuren 1a und 1b zeigen in schematischen Schnittdarstellungen eine Abwandlung und ein Ausführungsbeispiele eines hier beschriebenen optoelektronischen Bauteils.
Die Figuren 2a, 2b, 2c und 2d zeigen einzelne Fertigungsschritte zur Herstellung zumindest einer Abwandlung eines hier beschriebenen Bauteils.
Die Figuren 3a, 3b und 3c zeigen das Bauteil nach einzelnen Fertigungsschritten in schematischen Draufsichten zur Herstellung zumindest eines Ausführungsbeispiels eines hier beschriebenen Bauteils.
Die Figuren 4a, 4c und 4e zeigen schematische Draufsichten eines optoelektronischen Bauteils gemäß eines hier beschriebenen Ausführungsbeispiels,
Die Figur 4b und 4d zeigt eine Abwandlung eines optoelektronischen Bauteils in Draufsicht.

In den Ausführungsbeispielen und den Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

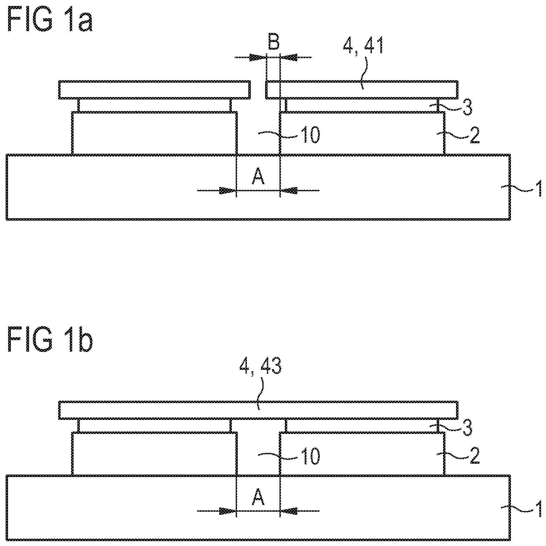

In der Figur 1a ist anhand einer schematischen Schnittdarstellung eine Abwandlung eines hier beschriebenes optoelektronisches Halbleiterbauteil mit einem Träger 1 dargestellt. Die matrixartig angeordneten Halbleiterchips 2 sind auf dem gemeinsamen Träger 1 aufgebracht.

Der Träger 1 kann mit einem Kunststoff, einer Keramik oder einem Metall gebildet sein. Der Träger 1 ist als eine Leiterplatte oder, falls der Träger 1 metallisch ist, als ein Trägerrahmen (Leadframe) des Bauteils ausgebildet.

Die Halbleiterchips 2 sind mit dem Träger 1 leitend verbunden. Auf den Halbleiterchips 2 sind die Konverterelemente 3 aufgebracht, welche die von den Halbleiterchips 2 primär emittierte Strahlung in Strahlung anderer Wellenlänge umwandeln. Im vorliegenden Beispiel handelt es sich bei den Konverterelementen 3 um jeweils eine optische CLC-Schicht (Chip Level Konversionsschicht), die das von den Halbleiterchips 2 primär emittierte blaue Licht teilweise in gelbes Licht umwandelt. Bei den Konverterelementen 3 kann es sich jeweils um eine Schicht gebildet mit Silikon oder aus transparenter Keramik handeln, in die Konverterpartikel eingebracht sind.

Auf den Konverterelementen 3 sind jeweils diffus Licht streuende Streuelemente 4 in Form von Licht streuenden Plättchen 41 aufgebracht, die die jeweiligen Halbleiterchips 2 seitlich um die Länge B überragen. Vorliegend überragen die Licht streuenden Plättchen 41 die Halbleiterchips 2 jeweils um höchstens 75 µm. Die Licht streuenden Plättchen 41 weisen vorliegend eine Dicke von 750 µm auf. Bei dem Material der Licht streuenden Plättchen 41 handelt es sich um ein Silikon, welches vor dem Aushärten zu den Plättchen 4 mit strahlungsstreuenden Partikeln aus Aluminiumoxid vermengt wurde. Die Konzentration der Aluminiumoxidpartikel in den Licht streuenden Plättchen 41 beträgt 5 Gew-%. Mit einer solchen Konzentration können die deutlichsten Effekte in Bezug auf Minimierung der Leuchtdichteunterschiede entlang einer Strahlungsaustrittsfläche des Bauteils und Vermeidung der Blendeffekte für einen externen Betrachter erzielt werden. Die Strahlungsaustrittsfläche des Bauteils ist durch die den Halbleiterchips 2 abgewandten Oberseiten der Licht streuenden Plättchen 41 gebildet und festgelegt. Weiter kann ein homogener Farbeindruck über die gesamte Strahlungsaustrittsfläche erreicht werden, so dass für einen externen Betrachter das Bauteil gemäß einem vorgebbaren Farbeindruck erscheint. Der Abstand der einzelnen Seitenflächen von Halbleiterchip zu Halbleiterchip ist mit A festgelegt und liegt im Bereich zwischen 10 bis 150 µm. In vorliegendem Beispiel beträgt der Abstand A 100 µm.

Die Figur 1b zeigt ein Ausführungsbeispiel des optoelektronischen Halbleiterbauteils, bei dem das Streuelement 4 durch eine zusammenhängende Schicht gebildet ist. Im vorliegenden Beispiel handelt es sich um eine Schicht in Form einer zusammenhängenden Licht streuenden Folie 43. Die Licht streuende Folie 43 weist eine Dicke von 10 bis 50 µm, vorliegend von 30 µm, auf. Die Licht streuende Folie 43 ist wiederum mit einem für elektromagnetische Strahlung transparenten Silikon gebildet, in das vor dem Aushärten die strahlungsstreuenden Partikel aus Aluminiumoxid in einer Konzentration von 5 Gew-% eingebracht wurden. Die Licht streuende Folie 43 überdeckt bei einer Draufsicht auf das Bauteil alle Halbleiterchips und Zwischenräume 10 zwischen den Halbleiterchips vollständig. Vorteilhaft wird so erreicht, dass die dunkel erscheinenden Zwischenräume 10 mit der von der Licht streuenden Folie 43 auch über Bereichen der Zwischenräume 10 ausgehend diffus gestreuten Strahlung überlagert werden. Dadurch, dass die Licht streuende Folie 43 lückenlos und zusammenhängend als eine Schicht ausgebildet ist, werden die Zwischenräume 10 noch vollständiger und gleichmäßiger durch die von der Licht streuenden Folie 43 gestreute elektromagnetische Strahlung überlagert beziehungsweise überdeckt, als es bei dem in Figur 1a beschriebenen Ausführungsbeispiel der Fall ist. Vorteilhaft wird so vermieden, dass ein externer Betrachter die dunkel erscheinenden Zwischenräume 10 zwischen den Halbleiterchips erkennen kann und wahrnimmt. Vorteilhaft werden die weiteren gewünschten Effekte erzielt, wie sie bereits in den Ausführungen zu dem Ausführungsbeispiel der Figur 1a genannt wurden. Ganz besonders ist ein solches Streuelement 4 für ein Bauteil mit einer großen Anzahl von Halbleiterchips 2 geeignet, da die Strahlungsaustrittsfläche dann großflächig ist und so nicht nur die bereits genannten vorteilhaften Leuchteigenschaften des Bauteils zur Geltung kommen, sondern die Licht streuende Folie 43 in nur einem einzigen Verfahrensschritt aufgebracht werden kann. Diese Ausgestaltung des Streuelements 4 ist daher nicht nur kosten-, sondern in ihrer Herstellung auch zeitsparend.

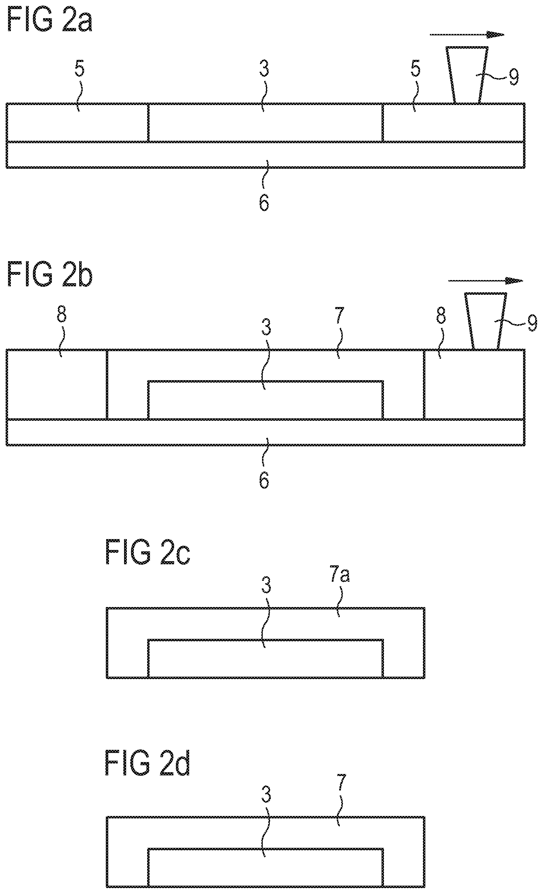

In Verbindung mit den Figuren 2a, 2b, 2c und 2d wird anhand schematischer Schnittdarstellungen ein Verfahren zur Herstellung eine Bauelements entsprechend beispielsweise der Figur 1a näher erläutert. Die Figur 2a zeigt eine Folie, die als Trägerelement 6 für den Herstellungsprozess dient. Auf dem Trägerelement 6 ist eine erste Schablone 5 aufgebracht. Mittels eines Aufdruckmittels, in diesem Beispiel handelt es sich um eine Rakel 9, wird das Material des Konverterelements 3 in die Öffnungen der Schablone 5 eingebracht. Bei dem Material des Konverterelements 3 kann es sich um eine Schicht mit Silikon oder aus einem Keramikmaterial handeln, in die Konverterpartikel eingebracht sind. Nach dem Aufbringen des Konverterelements 3 mittels Siebdruck auf die Schablone 5 und einem gegebenenfalls aushärtendem Material wird die Schablone 5 von der Trägerelement 6 und vom Konverterelement 3 entfernt. Das Konverterelement 3 bildet eine erste Schicht auf dem Trägerelement 6.

In einem zweiten Schritt wird eine zweite Schicht 7 auf das Trägerelement 6 aufgebracht und mittels eines zweiten Siebdruckprozesses unter Verwendung der Rakel 9 ein Streuelement 4 auf die zweite Schablone 8 als zweite Schicht 7 aufgerakelt. Die zweite Schicht 7 bedeckt das Konverterelement 3 an allen freiliegenden Außenflächen und steht mit dem Konverterelement 3 in direktem Kontakt, siehe Figur 2b. Nach dem Aufbringen der zweiten Schicht 7 auf das Konverterelement 3 wird die zweite Schablone 8 sowohl von dem Trägerelement 6 als auch von dem Verbund bestehend aus Konverterelement 3 und der zweiten Schicht 7 entfernt. Beispielsweise handelt es sich dabei um eine Konverterschicht, die das vom Konverterelement 3 emittierte Licht in farbiges Licht umwandelt.

Handelt es sich um eine zweite Konverterschicht 7a, kann der Vorgang wiederholt werden und in einem dritten oder weiteren Schritt wird das Streuelement auf die zweite Konverterschicht 7a aufgebracht.

Alternativ zum hier beschriebenen Siebdruckverfahren kann ein dickflüssiges Mittel auf die Schablonen 5 beziehungsweise 8 aufgetröpfelt werden. Mittels eines Spincoating-Prozesses wird anschließend das Material auf der Oberfläche des Trägerelements 6 verteilt und kann dann aushärten. Der Verbund wird anschließend auf jeweils einen der Halbleiterchips 2 aufgebracht. Das Aufbringen kann beispielsweise mittels Plättchentransfer und/oder Kleben geschehen.

Ebenso ist es möglich, mittels geeigneter Schablonen eine Vielzahl matrixartig angeordneter Konverterelemente 3 durch einen einzelnen Herstellungsprozess, beispielsweise mittels eines Siebdruckprozesses, unter Verwendung einer entsprechend beschaffenen Schablone 5 herzustellen. Mit Hilfe beispielsweise eines zweiten Siebdruckprozesses wird eine zweite plattenartige Schicht 7 gebildet, die alle freiliegenden Außenflächen der Konverterelemente 3 abdeckt und zusammenhängend ist. Nach dem Aushärten und dem Entfernen sowohl dem Trägerelement 6 als auch der zweiten Schablone 8 ergibt sich so ein plattenartiger Verbund bestehend aus den Konverterelementen 3 und die die Konverterelemente 3 umgebende, zusammenhängende zweite Schicht 7. Anschließend kann der plattenartige Verbund direkt auf die matrixartig angeordneten Halbleiterchips 2 aufgebracht werden. Der Verbund überdeckt dann in einer Draufsicht auf das Bauteil alle Halbleiterchips 2 und die Zwischenräume 10 des Bauteils. Vorteilhaft ist ein solcher Prozess ganz besonders kostengünstig.

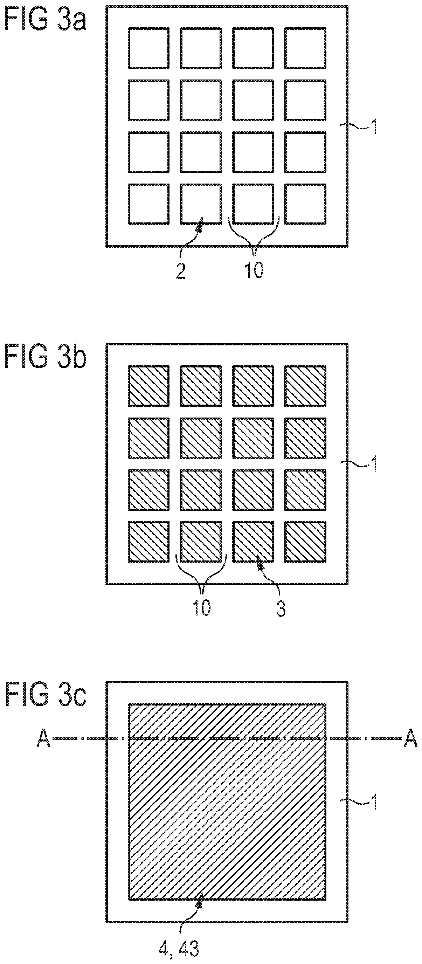

Die Figur 3a zeigt in einer schematischen Draufsicht einen Träger 1, auf dem sich die Halbleiterchips 2 befinden und aufgebracht sind. Die Halbleiterchips 2 sind matrixartig in Form von Zeilen und Spalten angeordnet.

Die Figur 3b zeigt die matrixartig angeordneten Halbleiterchips gemäß der Figur 3a, bei denen zusätzlich auf den Halbleiterchips 2 die Konverterelemente 3 in Form einzelner Plättchen aufgebracht wurden. Das Aufbringen der Konverterelemente 3 auf je einem dem jeweiligen Konverterelement zugeordneten Halbleiterchip kann mittels beispielsweise Plättchentransfer (auch Pick & Place) und/oder Kleben geschehen.

Die Figur 3c zeigt das fertige optoelektronische Halbleiterbauteil, bei dem das Streuelement 4 in Form einer zusammenhängenden Schicht, beispielsweise der zusammenhängenden Licht streuenden Folie 43, auf die matrixartig angeordneten Halbleiterchips 2 aufgebracht ist. In der Draufsicht bedeckt die Licht streuende Folie 43 sowohl die Oberflächen der Halbleiterchips 2, als auch alle Zwischenräume 10.

Betrachtet man das fertige optoelektronische Halbleiterbauteil gemäß der Figur 3C entlang einer Linie A-A in einer Seitenansicht, so ergibt sich ein optoelektronisches Halbleiterbauteil gemäß der Figur 1b.

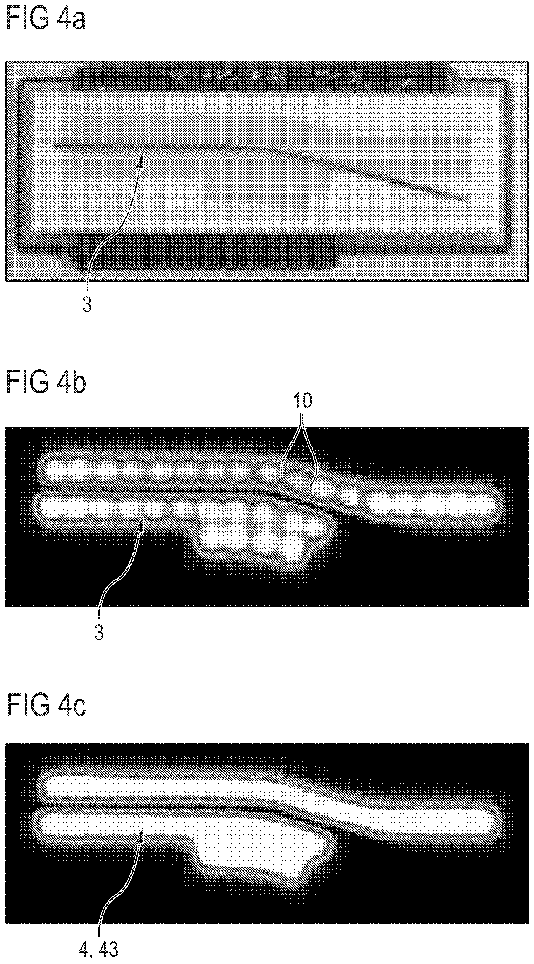

Die Figur 4a zeigt eine schematische Draufsicht auf ein derartiges optoelektronisches Halbleiterbauteil im ausgeschalteten Betriebszustand. Zu erkennen sind die matrixartig angeordneten Halbleiterchips 3 und die etwas heller erscheinenden Stellen, die die auf den Halbleiterchips 2 aufgebrachten Konverterelemente 3 darstellen.

Figur 4b zeigt eine Abwandlung des optoelektronischen Halbleiterbauteils im eingeschalteten Betriebszustand ohne aufgebrachte Streuelemente. Die hell leuchtenden Punkte zeigen die für einen externen Beobachter erkennbaren Emissionsflächen der Halbleiterchips 2. Zwischen den Halbleiterchips 2 befinden sich jeweils Zwischenräume 10, die dunkler erscheinen. Erkennbar ist, dass die Leuchtdichteunterschiede von Halbleiterchip zu Zwischenraum stark hervortreten.

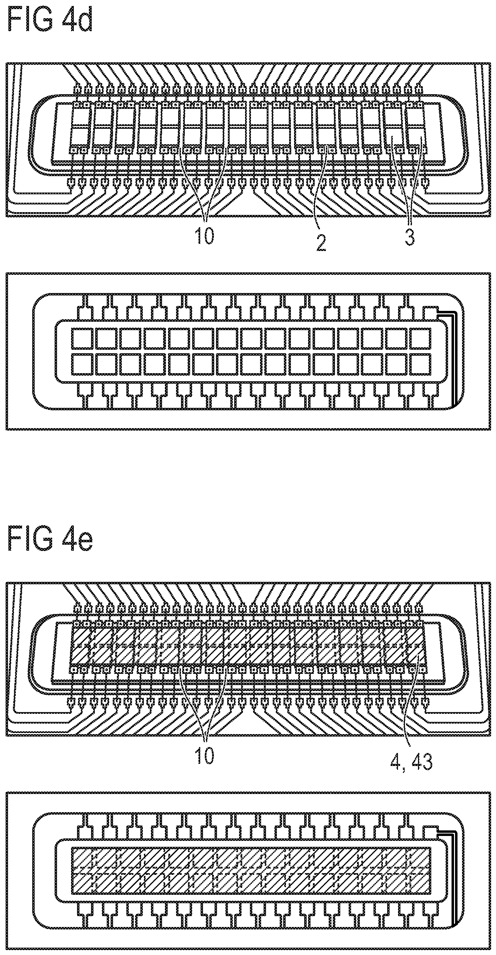

Figur 4c zeigt das optoelektronische Halbleiterbauteil im eingeschalteten Betriebszustand, bei dem über den Halbleiterchips 2 ein Streuelement 4 in Form der zusammenhängenden Folie 43 aufgebracht wurde. Das Streuelement 4 homogenisiert die hier gezeigten ortsabhängigen Leuchtdichteunterschiede. Die teilweise noch zu erkennenden heller leuchtenden Punkte zeigen die für einen externen Betrachter erkennbaren Emissionsflächen der Halbleiterchips 2. Die Zwischenräume 10 sind nach Aufbringen des Streuelements 4 nicht mehr erkennbar, so dass durch das Streuelement 4 die Leuchtdichteunterschiede von Halbleiterchip zu Zwischenraum vermieden werden können. Die Figuren 4d und 4f zeigen Draufsichten auf ein solches optoelektronisches Bauteil.

In Figur 4d ist ein Bauteil ohne Streuelemente 4 gezeigt, bei dem die matrixartig angeordneten Halbleiterchips 2 und die auf den Halbleiterchips 2 aufgebrachten Konverterelemente 3 erkennbar sind. Die gitterartigen, dunklen Stellen sind die Zwischenräume 10 des Bauteils.

Figur 4e zeigt in einer Draufsicht ein fertiges optoelektronisches Bauteil, bei dem das Streuelement 4 eine zusammenhängende Folie bildet, die sowohl alle Halbleiterchips als auch alle Zwischenräume 10 lückenlos überdeckt. Es geht hervor, dass die Zwischenräume 10 deutlich schwerer zu erkennen sind.

## Patentansprüche

1. Optoelektronisches Halbleiterbauteil mit
- einer Vielzahl von insbesondere matrixartig angeordneten, strahlungsemittierenden Halbleiterchips (2), wobei die Halbleiterchips (2) auf einem gemeinsamen Träger (1) aufgebracht sind, und wobei die Halbleiterchips (2) jeweils eine vom Träger (1) abgewandte Strahlungsaustrittsfläche aufweisen,
- einer Vielzahl von Konverterelementen (3), die den Halbleiterchips (2) zur Konversion von von den Halbleiterchips (2) emittierter elektromagnetischer Strahlung nachgeordnet sind,
- genau einem Streuelement (4) zum diffusen Streuen von von den Halbleiterchips (2) emittierter elektromagnetischer Strahlung, das alle Halbleiterchips (2) überdeckt, wobei das genau eine Streuelement (4) eine zusammenhängende Strahlungsaustrittsfläche aufweist, wobei
- das genau eine Streuelement (4) eine Licht streuende Folie (43) oder ein Licht streuendes Plättchen (41) ist, und
- das genau eine Streuelement (4) mit den Konverterelementen (3) in direktem Kontakt steht,
- die Konverterelemente (3) und das genau eine Streuelement (4) einen Verbund bilden, der auf den zugehörigen Halbleiterchips (2) mittels eines Klebers aufgebracht ist, so dass jedes Konverterelement (3) eineindeutig einem Halbleiterchip (2) zugeordnet ist, wobei die Konverterelemente (3) ausschließlich die Strahlungsaustrittsflächen der zugehörigen Halbleiterchips (2) bedecken, so dass die Konverterelemente (3) Seitenflächen der zugehörigen Halbleiterchips (2) nicht bedecken, wobei die Seitenflächen quer zu den Strahlungsaustrittsflächen verlaufen.

2. Optoelektronisches Halbleiterbauteil nach Anspruch 1, bei dem die Licht streuende Folie (43) eine Dicke zwischen 10 bis 50 µm umfasst.

3. Optoelektronisches Halbleiterbauteil nach Anspruch 1 oder 2,
bei dem der seitliche Abstand zwischen benachbarten Halbleiterchips zwischen 10 und 150 µm beträgt.

4. Optoelektronisches Halbleiterbauteil nach einem der vorhergehenden Ansprüche,
bei dem das genau eine Streuelement (4) mit einem Matrixmaterial gebildet ist, in das strahlungsstreuende Partikel eingebracht sind.

5. Optoelektronisches Halbleiterbauteil nach Anspruch 4, bei dem zumindest ein strahlungsstreuendes Partikel aus zumindest einem der folgenden Materialien besteht oder eines der folgenden Materialien enthält: SiO₂, ZrO₂, TiO₂, oder AlₓO_{y}.

6. Optoelektronisches Halbleiterbauteil nach Anspruch 4 oder 5,
bei dem die Konzentration der strahlungsstreuenden Partikel im Matrixmaterial größer als 1 Gew-% ist.

7. Optoelektronisches Halbleiterbauteil nach einem der vorhergehenden Ansprüche,
bei dem das genau eine Streuelement (4) mit einem Matrixmaterial gebildet ist, in das Mikrostrukturen eingebracht sind.

8. Optoelektronisches Halbleiterbauteil nach einem der vorhergehenden Ansprüche,
wobei das genau eine Streuelement (4) die den Halbleiterchips (2) zugeordneten Konverterelemente (3) seitlich überragt.

9. Optoelektronisches Halbleiterbauteil nach Anspruch 8, wobei das genau eine Streuelement (4) alle freiliegenden Seitenflächen des Konverterelements (3), welche nicht von dem Halbleiterchip (2) bedeckt sind, bedeckt.

10. Verfahren zur Herstellung eines optoelektronischen Halbleiterbauelements mit den folgenden Schritten:
- Bereitstellen eines Trägerelements (6),
- Bilden einer Vielzahl von Konverterelementen (3) mittels eines ersten Siebdruckprozesses auf dem Trägerelement (6),
- Bilden genau eines Streuelements (4) auf die freiliegenden Außenflächen der Konverterelemente (3) mittels eines zweiten Siebdruckprozesses, so dass ein Verbund aus den Konverterelementen (3) und dem genau einen Streuelement (4) geformt wird,
- Ablösen des Trägerelements (6) von dem Verbund,
- anschließendes Aufbringen des Verbunds bestehend aus den Konverterelementen (3) und dem genau einen Streuelement (4) auf eine Vielzahl strahlungsemittierender Halbleiterchips (2) mittels eines Klebers, sodass jedem Halbleiterchip (2) ein Konverterelement (3) eineindeutig zugeordnet wird.

11. Verfahren nach Anspruch 10,
wobei ein optoelektronisches Halbleiterbauteil gemäß einem der Ansprüche 1 bis 9 hergestellt wird.

## Claims

1. Optoelectronic semiconductor device with
- a plurality of radiation-emitting semiconductor chips (2), in particular arranged in a matrix-like manner, wherein the semiconductor chips (2) are mounted on a common carrier (1), and wherein the semiconductor chips (2) each have a radiation exit surface facing away from the carrier (1),
- a plurality of converter elements (3) arranged downstream of the semiconductor chips (2) for converting electromagnetic radiation emitted by the semiconductor chips (2),
- exactly one scattering element (4) for diffusely scattering electromagnetic radiation emitted by the semiconductor chips (2), which covers all semiconductor chips (2), wherein the exactly one scattering element (4) has a contiguous radiation exit surface, wherein
- the exactly one scattering element (4) is a light scattering film (43) or a light scattering platelet (41), and
- the exactly one scattering element (4) is in direct contact with the converter elements (3),
- the converter elements (3) and the exactly one scattering element (4) form a composite which is applied to the associated semiconductor chips (2) by means of an adhesive, so that each converter element (3) is uniquely assigned to a semiconductor chip (2), wherein the converter elements (3) exclusively cover the radiation exit surfaces of the associated semiconductor chips (2), so that the converter elements (3) do not cover side surfaces of the associated semiconductor chips (2), wherein the side surfaces extend transversely to the radiation exit surfaces.

2. Optoelectronic semiconductor device according to claim 1, in which the light scattering film (43) has a thickness between 10 to 50 µm.

3. Optoelectronic semiconductor device according to claim 1 or 2,
in which the lateral distance between adjacent semiconductor chips is between 10 and 150 µm.

4. Optoelectronic semiconductor device according to any of the preceding claims,
wherein the exactly one scattering element (4) is formed with a matrix material into which radiation-scattering particles are introduced.

5. Optoelectronic semiconductor device according to claim 4,
wherein at least one radiation-scattering particle consists of at least one of the following materials or contains one of the following materials: SiO₂, ZrO₂, TiO₂, or AlₓO_{y}.

6. Optoelectronic semiconductor device according to claim 4 or 5,
wherein the concentration of the radiation-scattering particles in the matrix material is greater than 1% by weight.

7. Optoelectronic semiconductor device according to any of the preceding claims,
wherein the exactly one scattering element (4) is formed with a matrix material, into which microstructures are introduced.

8. Optoelectronic semiconductor device according to any of the preceding claims,
wherein the exactly one scattering element (4) projects laterally beyond the converter elements (3) assigned to the semiconductor chips (2).

9. Optoelectronic semiconductor device according to claim 8, wherein the exactly one scattering element (4) covers all exposed side surfaces of the converter element (3) which are not covered by the semiconductor chip (2).

10. Method for producing an optoelectronic semiconductor device, comprising the following steps:
- providing a support element (6),
- forming a plurality of converter elements (3) by means of a first screen printing process on the support element (6),
- forming exactly one scattering element (4) on the exposed outer surfaces of the converter elements (3) by means of a second screen printing process, so that a composite of the converter elements (3) and the exactly one scattering element (4) is formed,
- removing the support element (6) from the composite,
- subsequently applying the composite consisting of the converter elements (3) and the exactly one scattering element (4) to a plurality of radiation-emitting semiconductor chips (2) by means of an adhesive, so that a converter element (3) is uniquely assigned to each semiconductor chip (2).

11. Method according to claim 10,
wherein an optoelectronic semiconductor device according to any of claims 1 to 9 is produced.

## Revendications

1. Composant semi-conducteur optoélectronique comportant
- une pluralité de puces semi-conductrices (2) émettrices de rayonnement, particulièrement disposées de manière matricielle, les puces semi-conductrices (2) étant montées sur un support (1) commun et présentant chacune une surface de sortie de rayonnement opposée au support (1),
- une pluralité d'éléments convertisseurs (3) disposés en aval des puces semi-conductrices (2) pour convertir le rayonnement électromagnétique émis par les puces semi-conductrices (2),
- un seul élément de diffusion (4) pour la diffusion sporadique du rayonnement électromagnétique émis par les puces semi-conductrices (2), couvrant toutes les puces semi-conductrices (2), le seul élément de diffusion (4) présentant une surface continue de sortie de rayonnement,
- le seul élément de diffusion (4) étant un film diffuseur de lumière (43) ou une plaquette (41) diffuseuse de lumière,
et
- le seul élément de diffusion (4) étant en contact direct avec les éléments convertisseurs (3),
- les éléments convertisseurs (3) et le seul élément de diffusion (4) formant un composite appliqué sur les puces semi-conductrices (2) associées au moyen d'un adhésif, de sorte que chaque élément convertisseur (3) soit affecté de manière biunivoque à une puce semi-conductrice (2),
les éléments convertisseurs (3) recouvrant exclusivement les surfaces de sortie de rayonnement des puces semi-conductrices (2) associées, de sorte que les éléments convertisseurs (3) ne recouvrent pas les surfaces latérales des puces semi-conductrices (2) associées, les surfaces latérales s'étendant transversalement aux surfaces de sortie du rayonnement.

2. Composant semi-conducteur optoélectronique selon la revendication 1,
dans lequel le film diffuseur de lumière (43) a une épaisseur comprise entre 10 et 50 µm.

3. Composant semi-conducteur optoélectronique selon la revendication 1 ou 2,
dans lequel la distance latérale entre les puces semi-conductrices adjacentes est comprise entre 10 et 150 µm.

4. Composant semi-conducteur optoélectronique selon l'une des revendications précédentes,
dans lequel le seul élément de diffusion (4) est formé d'un matériau matriciel dans lequel des particules diffusant le rayonnement sont introduites.

5. Composant semi-conducteur optoélectronique selon la revendication 4,
dans lequel au moins une particule diffusant le rayonnement est constituée d'au moins l'un des matériaux suivants ou contient l'un des matériaux suivants : SiO₂, ZrO₂, TiO₂ ou AlₓO_{y}.

6. Composant semi-conducteur optoélectronique selon la revendication 4 ou 5,
dans lequel la concentration des particules diffusant le rayonnement dans le matériau matriciel est supérieure à 1 % en poids.

7. Composant semi-conducteur optoélectronique selon l'une des revendications précédentes,
dans lequel le seul élément de diffusion (4) est formé d'un matériau matriciel dans lequel des microstructures sont introduites.

8. Composant semi-conducteur optoélectronique selon l'une des revendications précédentes,
dans lequel le seul élément de diffusion (4) dépasse latéralement des éléments convertisseurs (3) affectés aux puces semi-conductrices (2).

9. Composant semi-conducteur optoélectronique selon la revendication 8,
dans lequel le seul élément de diffusion (4) couvre toutes les surfaces latérales exposées de l'élément convertisseur (3) qui ne sont pas couvertes par la puce semi-conductrice (2) .

10. Procédé de fabrication d'un composant semi-conducteur optoélectronique, comprenant les étapes suivantes :
- mise à disposition d'un élément de support (6),
- mise en place d'une pluralité d'éléments convertisseurs (3) au moyen d'un premier procédé de sérigraphie sur l'élément de support (6),
- mise en place d'un seul élément de diffusion (4) sur les surfaces extérieures exposées des éléments convertisseurs (3) au moyen d'un deuxième procédé de sérigraphie, de sorte qu'un composite des éléments convertisseurs (3) et de l'élément de diffusion (4) soit formé,
- retrait de l'élément de support (6) du composite,
- appliquer ensuite le composite constitué des éléments convertisseurs (3) et du seul l'élément de diffusion (4) sur une pluralité de puces semi-conductrices émettrices de rayonnement (2) au moyen d'un adhésif, de sorte qu'un élément convertisseur (3) soit affecté de manière biunivoque à chaque puce semi-conductrice (2).

11. Procédé selon la revendication 10,
dans lequel un composant semi-conducteur optoélectronique selon l'une des revendications 1 à 9 est fabriqué.
